# EUROPEAN PATENT APPLICATION

(11) **EP 1 302 981 A2**
(43) Date of publication of application: **16.04.2003**
(21) Application number: 02002111.9
(22) Date of filing: 28.01.2002
(51) Int. Cl.: H01L 21/768

(54) **Method of manufacturing semiconductor device having silicon carbide film**

(30) Priority: 10.10.2001 JP 2001312883
(71) Applicant: FUJITSU LIMITED, Kawasaki-shi, Kanagawa 211-8588 (JP)
(72) Inventor: Komada, Daisuke, Kasugai-shi, Aichi 487-0013 (JP); Kakamu, Katsumi, Kasugai-shi, Aichi 487-0013 (JP)
(74) Representative: Seeger, Wolfgang, Dipl.-Phys.

(57) **Abstract**

A first film is formed on a semiconductor substrate, the first film being made of material having a different etching resistance from silicon carbide. A second film of hydrogenated silicon carbide is formed on the first film. A resist film with an opening is formed on the second film. By using the resist mask as an etching mask, the second film is dry-etched by using mixture gas of fluorocarbon gas added with at least one of SF₆ and NF₃. The first film is etched by using the second film as a mask. A semiconductor device manufacture method is provided which utilizes a process capable of easily removing an etching stopper film or hard mask made of SiC.

## Description

### BACKGROUND OF THE INVENTION

### A) FIELD OF THE INVENTION

The present invention relates to a manufacture method for semiconductor devices, and more particularly to a semiconductor device manufacture method including an etching process which uses a hydrogenated silicon carbide film as a hard mask or etching stopper film.

### B) DESCRIPTION OF THE RELATED ART

A conventional method of forming a wiring pattern will be described briefly. On an interlayer insulating film on a semiconductor substrate, an aluminum (Al) film or tungsten (W) film is deposited and patterned to form a wiring pattern. Deposits on the sidewalls of the wiring pattern are removed by using alkali chemicals. Thereafter, an interlayer insulating film covering the wiring pattern is deposited by plasma enhanced chemical vapor deposition.

High integration of recent semiconductor integrated circuit devices makes wiring patterns finer. Finer wiring patterns greatly increase the parasitic capacitance between wiring patters so that the operation speed of a semiconductor integrated circuit is influenced to some degree. In order to reduce the parasitic capacitance between wiring patterns, techniques of forming an interlayer insulating film having a low dielectric constant and techniques of forming a wiring layer made of copper (Cu) having a low electric resistance are utilized nowadays. Known interlayer insulating film materials having a low dielectric constant include fluorosilicate glass (FSG), hydrogen silsesquioxane (HSQ), poly(aryl ether)s (There are known as FLARE of Allied Signal Inc, or SiLK of the Dow Chemical Company), and the like.

As one of interlayer insulating films, a silicon nitride (SiN) film is used which functions as a barrier film for preventing diffusion of Cu, an etching stopper film, or a cap film. SiN has a dielectric constant higher than SiO₂ so that it hinders low dielectric constant of an interlayer insulating film. As an alternative of SiN, silicon carbide (SiC) has drawn attention.

If SiC is used as an alternative of SiN, although the interlayer insulating film can have a low dielectric constant, a SiC film is more difficult to be etched than a SiN film. A SiC film, particularly a SiC film which contains Si-H bonds or Si-C bonds is more difficult to be etched because hydrogen desorbed during an etching process restricts the etching.

If a wiring pattern is to be formed by a damascene method using an interlayer film of organic insulating material, SiN is used as the material of a hard mask. If SiN is replaced with SiC, it is difficult to remove the hard mask after the organic insulating film under the hard mask is etched.

### SUMMARY OF THE INVENTION

It is an object of the present invention to provide a method of manufacturing a semiconductor device by utilizing an etching method capable of easily removing an etching stopper film or hard mask made of SiC.

According to one aspect of the present invention, there is provided a method of manufacturing a semiconductor device, comprising steps of: forming a first film on a semiconductor substrate, the first film being made of material having a different etching resistance from silicon carbide; forming a second film on the first film, the second film being made of hydrogenated silicon carbide; forming a resist film with an opening on the second film; dry-etching the second film by using the resist mask as an etching mask and mixture gas of fluorocarbon gas added with at least one of SF₆ and NF₃; and etching the first film by using the second film as a mask.

It is another object of the present invention to provide a method of manufacturing a semiconductor device, comprising steps of: preparing a substrate having a conductive region exposed on a partial area of an insulating surface of the substrate; forming a first film on the surface of the substrate, the first film being made of hydrogenated silicon carbide; forming a second film made of insulating material on the first film; forming a resist film with an opening on the second film; etching the second film by using the resist mask as an etching mask to form a recess and expose a partial surface area of the first film on the bottom of the recess; ashing and removing the resist film; dry-etching the first film exposed on the bottom of the recess by using mixture gas of fluorocarbon gas added with at least one of SF₆ and NF₃ to expose the conductive region of the substrate; and burying a conductive member in the recess.

It is another object of the present invention to provide a method of manufacturing a semiconductor device, comprising steps of: preparing a substrate having a conductive member exposed on a partial area of an insulating surface of the substrate; forming a first film on the surface of the substrate, the first film being made of hydrogenated silicon carbide; forming a second film made of insulating material on the first film, the insulating material having a different etching resistance from silicon carbide; forming a third film on the second film, the third film being made of hydrogenated silicon carbide; forming a resist film with an opening on the third film, the opening overlapping with a partial area of the conductive member as viewed along a line parallel to a normal to the substrate surface; etching the third film by using the resist mask as an etching mask and using mixture gas of fluorocarbon gas added with at least one of SF₆ and NF₃; etching the second film by using the resist mask as an etching mask under a condition that an etching rate of the second film is faster than an etching rate of the first film, to form a recess and expose a partial surface area of the first film on a bottom of the recess; ashing and removing the resist film; and dry-etching the first film exposed on the bottom of the recess by using mixture gas of fluorocarbon gas added with at least one of SF₆ and NF₃, to expose the conductive member of the substrate.

It is another object of the present invention to provide a method of manufacturing a semiconductor device, comprising steps of: preparing a substrate having a wiring exposed on a partial area of an insulating surface of the substrate; forming a first film on the surface of the substrate, the first film being made of hydrogenated silicon carbide; forming a second film made of insulating material on the first film, the insulating material having a different etching resistance from silicon carbide; forming a third film on the second film, the third film being made of hydrogenated silicon carbide; forming a first resist film with a first opening on the third film, the first opening overlapping with a partial area of the conductive member as viewed along a line parallel to a normal to the substrate surface; etching the third film by using the resist mask as an etching mask and using mixture gas of fluorocarbon gas added with at least one of SF₆ and NF₃ to expose a partial surface of the second film; removing the first resist film; forming a second resist film with a second opening on surfaces of the etched third film and exposed second film, the second opening being included in an area of the first opening and partially overlapping with the wiring; etching the second film at least to an intermediate depth thereof by using the second resist mask as an etching mask; removing the second resist film; etching the third film by using the partially etched third film as a mask to form a via hole reaching the first film in an area where the second opening is formed, and to form a wiring groove to an intermediate depth of the second film in an area where the first opening is formed and the second opening is not formed; dry-etching the first film exposed on the bottom of the via hole by using mixture gas of fluorocarbon gas added with at least one of SF₆ and NF₃, to expose the wiring; and burying insides of the via hole and wiring groove with a conductive member.

If mixture gas of fluorocarbon gas added with SF₆ or NF₃ is used as etching gasses, a film made of hydrogenated silicon carbide can be selectively etched.

According to another aspect of the invention, there is provided a method of manufacturing a semiconductor device, comprising steps of: forming a first film of silicon carbide on a surface of a semiconductor substrate by chemical vapor deposition using tetramethylsilane and carbon dioxide as source gasses and by setting a ratio of a flow rate of tetramethylsilane to a flow rate of carbon dioxide to a range from 0.2 to 0.6; forming a second film on the first film, the second film being made of insulating material having a different etching resistance from silicon carbide; forming a resist film with an opening; and etching the second film by using the resist film as an etching mask under a condition that an etching rate of the second film is faster than an etching rate of the first film to partially expose the first film.

A silicon carbide film deposited under the above-described conditions has a slow etching rate under SiO based etching conditions so that it can be used as an etching stopper.

As above, instead of conventionally used SiN, SiC having a low dielectric constant can be used as the material of a hard mask or etching stopper film. Parasitic capacitance between wiring patterns can be reduced and the operation speed of a semiconductor integrated circuit device can be improved.

### BRIEF DESCRIPTION OF THE DRAWINGS

Figs. 1A and 1 B are cross sectional views of a substrate illustrating a semiconductor device manufacturing method according to a first embodiment of the invention, and Fig. 1C is a cross sectional view of a substrate illustrating a comparison example.
Fig. 2 is a schematic diagram showing an RIE system used by the embodiment methods of the invention.
Figs. 3A to 3D are cross sectional views of a substrate illustrating a semiconductor device manufacturing method according to a second embodiment of the invention, and Fig. 3E is a cross sectional view of a substrate illustrating a comparison example.
Figs. 4A to 4E are cross sectional views of a substrate illustrating a semiconductor device manufacturing method according to a third embodiment of the invention, and Fig. 4F is a cross sectional view of a substrate illustrating a comparison example.
Figs. 5A to 5H are cross sectional views of a substrate illustrating a semiconductor device manufacturing method according to a fourth embodiment of the invention.
Fig. 6 is a graph showing the FT-IR results of a conventional SiC film.
Fig. 7 is a graph showing the FT-IR results of SiC films formed at different flow rate ratios between tetramethylsilane and CO₂.
Fig. 8 is a graph showing the relation between a flow rate ratio between tetramethylsilane and CO₂ and an etching rate of a SiC film.
Fig. 9 is a graph showing the relation between a flow rate ratio between tetramethylsilane and CO₂ and a stress shift.
Figs. 10A to 10N are cross sectional views of a substrate illustrating a semiconductor device manufacturing method utilizing the first to fifth embodiment methods.

### DETAILED DESCRIPTION OF THE PREFERRED EMBODIMENTS

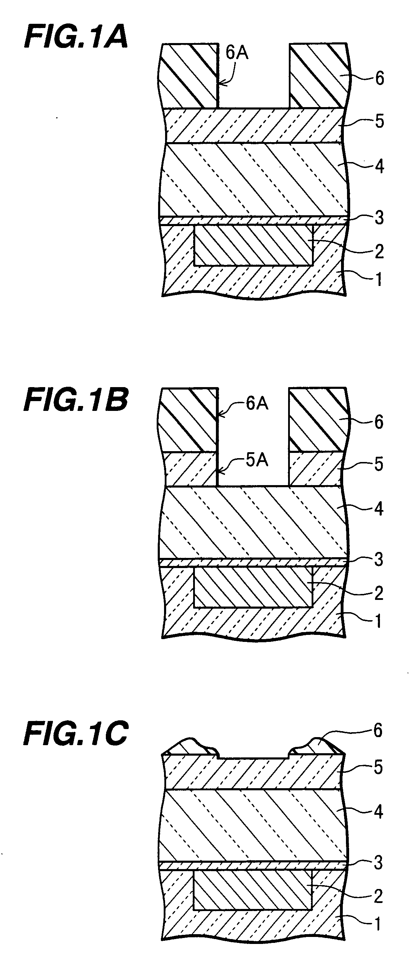

With reference to Figs. 1A to 1C, a semiconductor device manufacturing method according to a first embodiment of the invention will be described.

As shown in Fig. 1A, in the surface layer of an interlayer insulating film 1 formed on a semiconductor substrate, a copper wiring 2 is embedded. The copper wiring 2 is formed by a damascene method. An etching stopper film 3 of SiC having a thickness of 50 nm is formed on the interlayer insulating film 1 and copper wiring 2. The etching stopper film 3 can be formed by CVD using mixture gas of tetramethylsilane (Si(CH₃)₄), ammonium (NH₃) and nitrogen (N₂). The SiC film formed contains Si-H bonds and C-H bonds.

An interlayer insulating film 4 made of SiLK manufactured by the Dow Chemical Company and having a thickness of 500 nm is formed on the etching stopper film 3. A hard mask 5 of SiC having a thickness of 100 nm is formed on the interlayer insulating film 4. The hard mask 5 is formed by a method similar to the method of forming the etching stopper film 3. A resist film 6 is coated on the hard mask 5, the resist film having an opening 6A partially overlapping the wiring 2 as viewed along a line parallel to the normal to the substrate surface.

As shown in Fig. 1B, by using the resist film 6 as a mask, the hard mask is dry-etched to form an opening 5A through the hard mask 5.

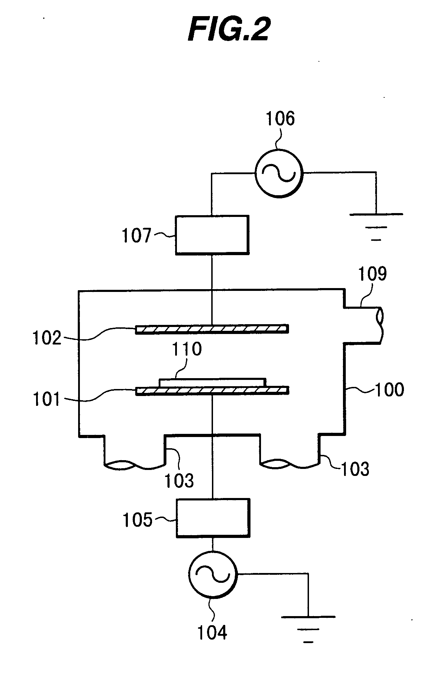

Fig. 2 is a schematic diagram showing the structure of a reactive ion etching (RIE) system to be used for etching the hard mask 5. In a chamber 100, a lower electrode 101 and an upper electrode 102 are disposed generally in parallel. Etching gas is introduced via a gas inlet port 109 into the chamber 100, whereas unreacted etching gas and reaction byproducts are drained from an air outlet port 103. A power source 106 applies a high frequency voltage of 27 MHz to the upper electrode 102 via an impedance matching circuit 107. A bias power source 104 applies a high frequency voltage of 800 kHz to the lower electrode 101 via an impedance matching circuit 105. A substrate 110 to be processed is placed on the lower electrode 101.

Next, the etching conditions of the hard mask 5 will be described. Etching gasses used were mixture gas of CHF₃, NF₃, Ar and O₂ at flow rates of 20 sccm, 10 sccm, 200 sccm, and 5 sccm, respectively. A pressure in the chamber 100 was 6.65 Pa (50 mTorr), a source power supplied to the upper electrode 102 was 2000 W, a bias power supplied to the lower electrode 101 was 1400 W, and a temperature of the lower electrode 101 was 20 °C.

Under these etching conditions, the opening 5A was able to be formed through the hard mask 5. After the opening 5A is formed, by using the resist film 6 and the hard mask 5 as a mask, the interlayer insulating film 4 is etched and then the etching stopper film 3 is etched to form a via hole. This etching is performed to lose the resist film 6.

Fig. 1C is a cross sectional view of a substrate illustrating a comparison example in which the hard mask 5 is etched by using etching gas not containing NF₃. Etching gasses used were mixture gas of CF₄, CHF₃, Ar and O₂ at flow rates of 20 sccm, 30 sccm, 200 sccm, and 8 sccm, respectively. A pressure in the chamber 100 was 5.3 Pa (40 mTorr), a source power supplied to the upper electrode 102 was 2500 W, a bias power supplied to the lower electrode 101 was 1500 W, and a temperature of the lower electrode 101 was 20 °C.

Under these etching conditions, a ratio (etching selection ratio) of an etching rate of the SiC film to an etching rate of the resist film is small. The resist mask 6 is therefore etched before the opening is formed through the hard mask 5. The opening was not able to be formed through the hard mask 5.

In general, CF₄ promotes etching and CHF₃ raises an etching selection ratio of a film to be etched to a resist film. It can be known that although the etching gasses used can provide resent a sufficient etching selection ratio when a SiN film is etched, they cannot provide a sufficient etching selection ratio when a SiC film which contains hydrogen is etched.

As described above, by adding NF₃ gas to the etching gasses, a sufficient etching selection ratio can be attained and the SiC film which contains hydrogen can be etched. Ar added to the etching gasses is used for ion assistance, and O₂ gas has a function of improving clearance of etching.

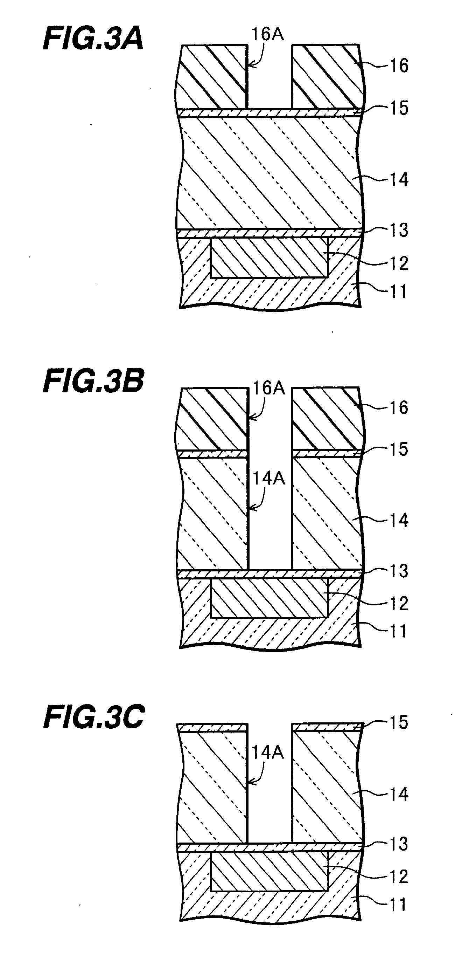

Next, with reference to Figs. 3A to 3D, a semiconductor device manufacture method according to a second embodiment of the invention will be described.

As shown in Fig. 3A, a Cu wiring 12 is buried in a groove formed in a surface layer of an interlayer insulating film 11 formed on a semiconductor substrate. The copper wiring 12 can be formed by a damascene method. An etching stopper film 13 of SiC having a thickness of 50 nm is formed on the interlayer insulating film 11 and copper wiring 12. The etching stopper film 13 is formed by a method similar to the method of forming the etching stopper film 3 of the first embodiment shown in Figs. 1A and 1B.

On the etching stopper film 13, an interlayer insulating film 14 of SiO₂ having a thickness of 1000 nm is formed by plasma enhanced chemical vapor deposition. On the interlayer insulating film 14, an antireflection film 15 of SiN having a thickness of 50 nm is formed by plasma enhanced chemical vapor deposition. A resist film 16 is coated on the antireflection film 15, the resist film having an opening 16A partially overlapping the wiring 12 as viewed along a line parallel to the normal to the substrate surface.

As shown in Fig. 3B, by using the resist mask 16 as a mask, the antireflection film 15 is dry-etched by using mixture gas of, for example, CHF₃ and O₂. The interlayer insulating film 14 is etched by using the RIE system shown in Fig. 2. For example, etching gasses used are mixture gas of C₄F₈, C₅F₈, Ar, CO and O₂. Under this etching condition, since the ratio (etching selection ratio) of an etching rate of the interlayer insulating film 14 to an etching rate of the etching stopper film 13 is high, the etching can be stopped almost when the etching stopper film 13 is exposed. A via hole 14A exposing a partial surface of the etching stopper film 13 on the bottom thereof can therefore be formed.

As shown in Fig. 3C, the resist film 16 is ashed and removed. In this case, since the surface of the wiring 12 is covered with the etching stopper film 13, the surface of the wiring 12 can be prevented from being oxidized.

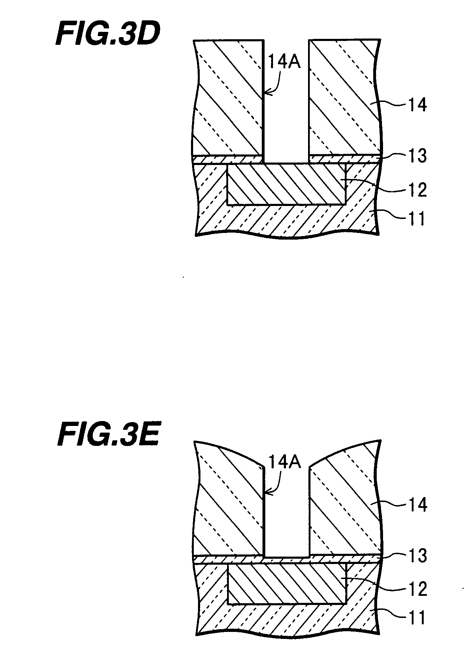

As shown in Fig. 3D, the etching stopper film 13 exposed on the bottom of the via hole 14A is dry-etched by using the RIE system shown in Fig. 2. Etching gasses used were mixture gas of CHF₃, NF₃, Ar and O₂ at flow rates of 30 sccm, 10 sccm, 200 sccm, and 8 sccm, respectively. A pressure in the chamber 100 was 6.65 Pa (50 mTorr), a source power supplied to the upper electrode 102 was 2000 W, a bias power supplied to the lower electrode 101 was 1500 W, and a temperature of the lower electrode 101 was 20 °C.

A partial surface area of the wiring 12 is therefore exposed on the bottom of the via hole 14A. Under the above-described etching conditions, the antireflection film 15 of SiN formed on the surface of the interlayer insulating film 14 is also etched and the upper surface of the interlayer insulating film 14 is exposed.

Similar to the first embodiment, in the second embodiment, since the mixture gas of CHF₃ added with NF₃ is used for etching, the etching stopper film 13 exposed on the bottom of the via hole 14A can be removed almost reliably.

Fig. 3E is a cross sectional view of a substrate illustrating a comparison example in which the etching is performed by using gasses not containing NF₃. Etching gasses used were mixture gas of CHF₃, Ar and O₂ at flow rates of 30 sccm, 200 sccm, and 8 sccm, respectively. A pressure in the chamber 100 was 6.65 Pa (50 mTorr), a source power supplied to the upper electrode 102 was 2000 W, a bias power supplied to the lower electrode 101 was 1500 W, and a temperature of the lower electrode 101 was 20 °C.

Under these etching conditions, the etching selection ratio of the etching stopper film 13 to the interlayer insulating film 14 is not sufficient. It is therefore difficult to reliably remove the etching stopper film 13 exposed on the bottom of the via hole 14A, and the upper region of the interlayer insulating film 14 near the via hole 14A is etched.

In the second embodiment, by adding NF₃ to fluorocarbon gas, the etching stopper film 13 made of SiC which contains hydrogen and exposed on the bottom of the via hole 14A can be removed almost reliably and the underlying wiring can be exposed.

Next, with reference to 4A to 4E, a semiconductor device manufacture method according to a third embodiment of the invention will be described. In the first and second embodiment, a via hole is formed through the interlayer insulating film on the copper wiring. In the third embodiment, an opening for disposing a bonding pad is formed.

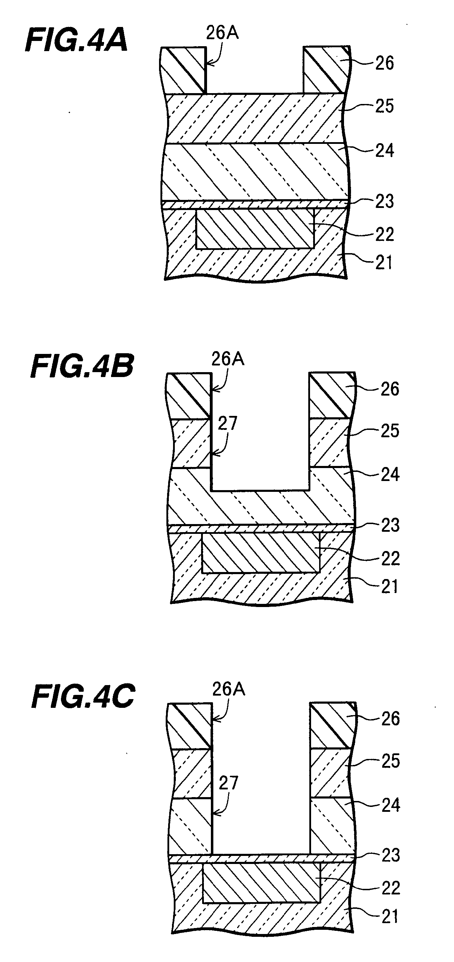

As shown in Fig. 4A, a copper wiring 22 is buried in a groove formed in a surface layer of an interlayer insulating film 21 formed on a semiconductor substrate. On the copper wiring 22 and interlayer insulating film 21, an etching stopper film 23 of SiC having a thickness of 50 nm, a protective film 24 of SiO₂ having a thickness of 400 nm and a cover film 25 of SiC having a thickness of 300 nm are sequentially formed. The etching stopper film 23 and cover film 25 are formed by plasma enhanced chemical vapor deposition similar to forming the etching stopper film 3 of the first embodiment shown in Fig. 1A. The protective film 24 is formed by plasma enhanced chemical vapor deposition similar to forming the interlayer insulating film 14 of the second embodiment shown in Fig. 3A.

A resist film 26 with an opening 26A is coated on the cover film 25. The opening 26A is included in the area of the wiring 22 as viewed along a line parallel to the normal to the substrate surface.

As shown in Fig. 4B, by using the resist film 26 as a mask, the cover film 25 is etched to form a recess 27. This etching is performed under the same etching conditions as those for etching the etching stopper film 13 of the second embodiment described with Fig. 3D. The recess 27 reaches the middle of the protective film 24 in the depth direction.

As shown in Fig. 4C, the protective film 24 is further etched to expose the etching stopper film 23 on the bottom of the recess 27. The protective film 24 is etched under the same etching conditions as those for etching the interlayer insulating film 14 of the second embodiment shown in Fig. 3B.

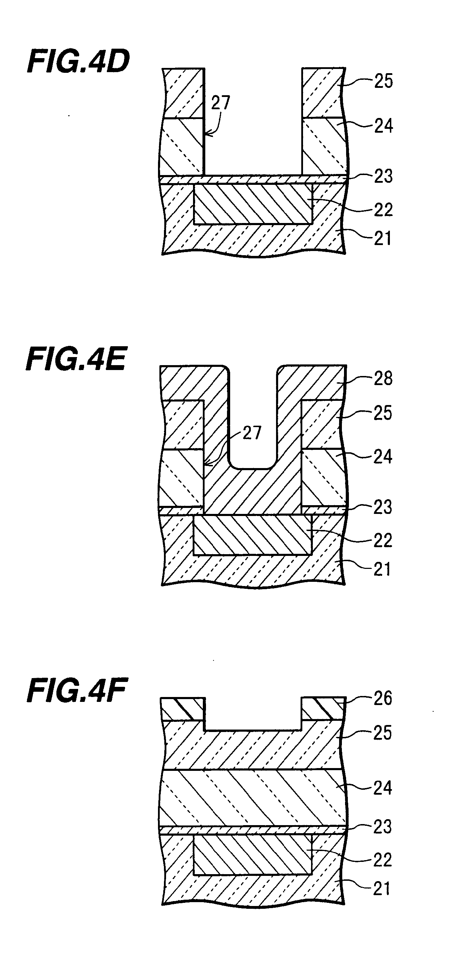

As shown in Fig. 4D, the resist film 26 left on the cover film 25 is ashed and removed.

As shown in Fig. 4E, the etching stopper film 23 exposed on the bottom of the recess 27 is etched. This etching is performed under the same etching conditions as those for etching the etching stopper film 13 of the second embodiment described with Fig. 3D. The copper wiring 22 is therefore exposed on the bottom of the recess 27. An Al film is formed covering the surface of the cover film 25 and the inner surface of the recess 27, and then patterned to form a bonding pad 28.

Also in the third embodiment, the etching process for the cover film 25 shown in Fig. 4B is performed by using mixture gas of CHF₃ and NF₃. It is therefore possible to form with good reproductivity the recess 27 through the cover film 25 made of hydrogenated SiC. Etching by using fluorocarbon gas not added with NF₃ cannot attain a sufficiently high etching selection ratio of the cover film 25 to the resist film 26. Therefore, as shown in Fig. 4F, the resist film 26 is thinned more and the recess 27 cannot be formed through the cover film 25.

In the first to third embodiments described above, etching gasses of CHF₃ added with NF₃ are used. Instead of CHF₃, fluorocarbon gas expressed by a general formula CₓH_{y}F_{z} (x, y and z are an integer satisfying x ≥ 1, y ≥ 0 and z ≥ 1) may be used. Instead of NF₃, SF₆ having a similar nature as NF₃ may also be used.

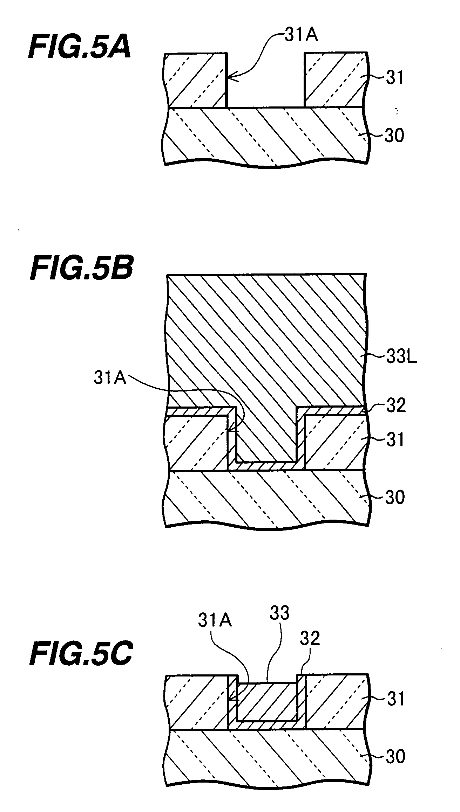

Next, with reference to Figs. 5A to 5H, a semiconductor device manufacture method according to a fourth embodiment will be described.

As shown in Fig. 5A, an interlayer insulating film 30 is formed on a semiconductor substrate. On the interlayer insulating film 30, a wiring layer insulating film 31 of FSG having a thickness of 500 nm is formed. For example, the wiring layer insulating film 31 can be formed by plasma enhanced chemical vapor deposition by using SiH₄, SiF₄, N₂O and N₂ as source gasses. A wiring groove 31A is formed through the wiring layer insulating film 31. Etching the wiring layer insulating film 31 can be performed by RIE by using mixture gas of C₄F₈, C₅F₈, Ar, CO and O₂. An etching stopper film of SiN or the like may be inserted between the interlayer insulating film 30 and wiring layer insulating film 31 to control the depth of the wiring groove 31A.

As shown in Fig. 5B, a barrier metal layer 32 of TaN having a thickness of 25 nm is formed by sputtering, the barrier metal layer covering the surface of the wiring layer insulating film 31 and the inner surface of the wiring groove 31A. A seed copper layer of 200 nm in thickness is formed on the surface of the barrier metal layer 32 by sputtering. On the seed copper layer, a copper film 33L of 1300 nm in thickness is formed by plating. The copper film 33L completely buries the inner space of the wiring groove 31A.

As shown in Fig. 5C, chemical mechanical polishing (CMP) is performed to remove an unnecessary barrier metal layer 32 and copper film 33L except those inside the wiring groove 31A. A copper wiring 33 is therefore left only in the wiring groove 31A. This CMP is performed under the conditions that dishing occurs to depress the upper surface of the copper wiring 33 lower than the upper surface of the wiring layer insulating film 31.

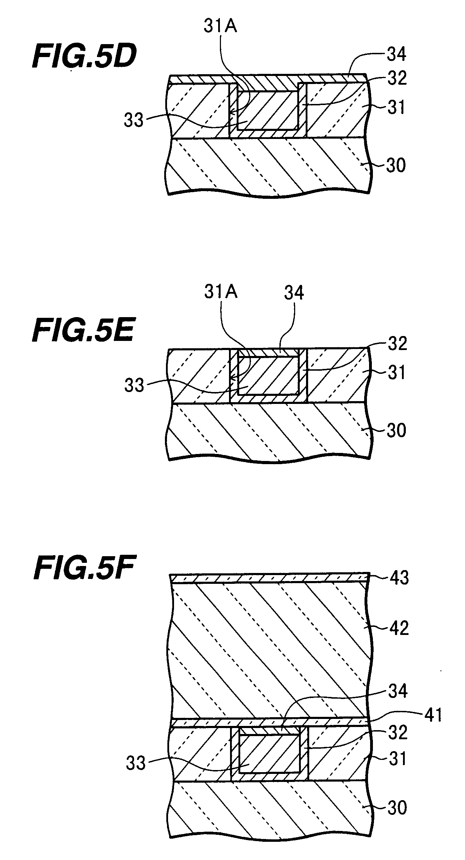

As shown in Fig. 5D, a barrier metal layer 34 of TaN is formed by sputtering, the barrier metal layer 34 covering the surfaces of the copper wiring 33 and wiring layer insulating film 31. The thickness of the barrier metal layer 34 is set so that the depression of the copper wiring 33 formed by dishing is buried with the carrier metal layer 34.

As shown in Fig. 5E, a second CMP is performed to remove an unnecessary barrier metal layer 34 excepting that inside of the wiring groove 31A. The copper wiring 33 is therefore formed inside the wiring groove 31A, the sidewalls, upper and bottom surfaces of the copper wiring being covered with the metal barrier layers 32 and 34.

Instead of performing the second CMP, etch-back may be performed. The first CMP may remove only the copper film 33L shown in Fig. 5B to leave the barrier metal layer 32 on the wiring layer insulating film 31, and the second CMP removes the barrier metal layer 32 together with the barrier metal layer 34 shown in Fig. 5D.

As sown in Fig. 5F, an etching stopper film 41 of SiC having a thickness of 50 nm, an interlayer insulating film 42 of FSG and an antireflection film 43 of SiN having a thickness of 50 nm are sequentially formed on the wiring layer insulating film 31 and copper wiring 33. The etching stopper film 41 is formed by a method similar to that of forming the etching stopper film 3 of the first embodiment shown in Fig. 1A. The interlayer insulating film 42 is formed by a method similar to that of forming the underlying wiring insulating film 31. The antireflection film 43 is formed by a method similar to that of forming the antireflection film of the second embodiment shown in Fig. 3A.

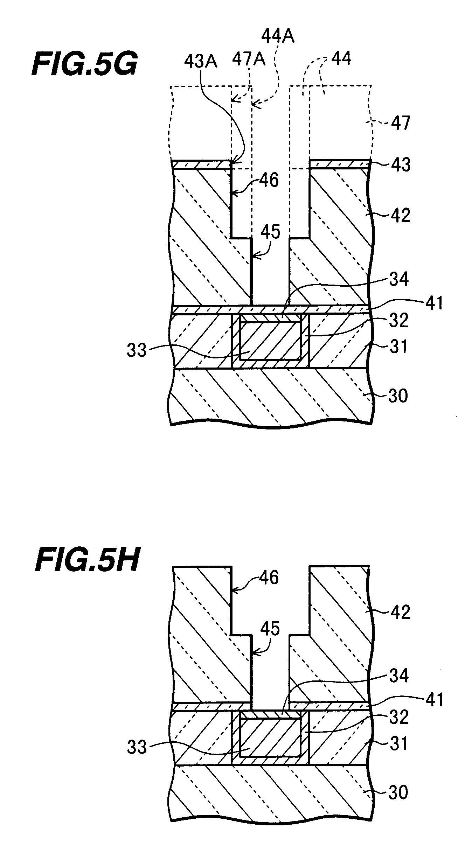

As shown in Fig. 5G, a resist film 44 is formed on the antireflection film 43. An opening 44A corresponding to a via hole is formed through the resist film 44. The opening 44A is positioned in a partial surface area of the copper wiring 33 as viewed along a line parallel to the normal to the substrate surface. By using the resist mask 44 as an etching mask, the antireflection film 43 and interlayer insulating film 42 are etched to the middle of the interlayer insulating film 42 in the depth direction to thereby form a via hole 45. The resist film 44 is thereafter removed.

Next, a resist film 47 is formed on the surface of the antireflection film 43. An opening 47A corresponding to a wiring groove is formed through the resist film 47. The opening 47A is positioned superposed upon the via hole 45. By using the resist film 47 as a mask, the antireflection film 43 and interlayer insulating film 42 are etched. Therefore, a wiring groove 46 corresponding to the opening 47A is formed and the via hole 45 is further etched to expose a partial surface area of the etching stopper film 41 on the bottom of the via hole 45.

As shown in Fig. 5H, the etching stopper film 41 exposed on the bottom of the via hole 45 is dry-etched to expose the underlying barrier metal layer 34. The etching conditions for the etching stopper film 41 will be described. Etching gasses used were mixture gas of CHF₃, SF₆, Ar and O₂ at flow rates of 30 sccm, 10 sccm, 200 sccm and 8 sccm, respectively. A pressure in the chamber 100 was 6.65 Pa (50 mTorr), a source power supplied to the upper electrode 102 was 2000 W, a bias power supplied to the lower electrode 101 was 1500 W, and a temperature of the lower electrode 101 was 20 °C.

In the fourth embodiment, since the mixture gas of CHF₃ added with SF₆ is used, the etching stopper film 41 on the bottom of the via hole 45 can be almost reliably etched. If copper is exposed on the etched surface, it is more preferable to add NF₃ to fluorocarbon gas than SF₆ in order to prevent corrosion of copper. In the fourth embodiment, since the upper surface of the copper wiring 33 is covered with the barrier metal layer 34 of TaN, SF₆ can be used. As the material of the barrier metal layer, Ta, Ti or TiN may be used in place of TaN.

In the first to fourth embodiments, an SiC film which contains hydrogen is etched by using mixture gas of fluorocarbon added with SF₆ or NF₃. Both SF₆ and NF₃ gasses may be added to fluorocarbon gas. In order to ensure the effects of adding SF₆ or NF₃, it is preferable to set a ratio of a flow rate of SF₆ or NF₃ to a flow rate of fluorocarbon gas to a range from 0.1 or to 0.5 or lower.

In the first to fourth embodiments, although CHF₃ is used as fluorocarbon gas, gas expressed by a general formula CₓH_{y}F_{z} (x, y and z are an integer satisfying x ≥ 1, y ≥ 0 and z ≥ 1) may be used. Examples of such gas are CF₄, CH₂F₂, C₄F₈, C₅F₈, C₄F₆ and the like.

High effects of adding NF₃ or SF₆ to etching gas can be obtained when a SiC film which contains hydrogen, particularly hydrogen of 20 atom %, is etched. It is preferable to set the hydrogen content to 50 atom % or less when an SiC film is used as a hard mask or an etching stopper film.

In the above embodiments, as the material of an interlayer insulating film, SiLK (the Dow Chemical Company), SiO₂, or FSG is used. Other insulating materials may also be used which have different etching resistance from that of SiC. For example, an interlayer insulating film may be a film made of phosphosilicate glass (PSG), a film of borophosphosilicate glass (BPSG), a film of hydrogen silsesquioxane (HSQ), a deposited film of tetraethylorthosilicate (TEOS), a film made by spin-on-glass, a film of carbon-containing silicon oxide (SiOC), a silicon-containing foaming porous film, an insulating film of organic material, or the like. Examples of the material of an organic insulating film are poly(aryl ether)s, i.e., FLARE of Allied Signal Inc.

In the above embodiments, although a parallel plate RIE system is used for dry etching, other etching systems may also be used such as an electron cyclotron resonance plasma (ECR plasma) etching system, an inductive coupled plasma (ICP) etching system and a helicon plasma etching system.

Also in the above embodiments, mixture gas of Si(CH₃))₄, NH₃ and N₂ is used as the source gasses for forming an SiC film by plasma enhanced chemical vapor deposition. Other gasses may also be used. For example, mixture gas of Si(CH₃)₃H, NH₃ and He may be used. The SiC film made of these source gasses is known by the merchandise name BLOk of Applied Materials Inc.

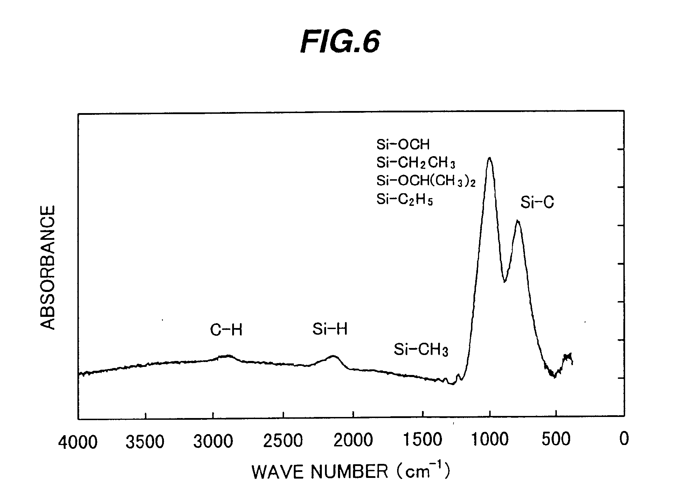

Next, with reference to Figs. 6 to 9, a semiconductor manufacture method according to a fifth embodiment will be described. In the first to fourth embodiments, the semiconductor device manufacture methods are characterized in a process of etching an SiC film which contains hydrogen. The fifth embodiment is characterized in a method of forming an SiC film.

The etching stopper film 13 of SiC of the second embodiment shown in Fig. 3B has a function of an etching stopper film when the via hole 14A is formed through the upper level interlayer insulating film 14. It is therefore necessary that under the etching conditions for the interlayer insulating film 14, the etching rate of the etching stopper film 13 is sufficiently slower than that of the interlayer insulating film 14.

An etching selection ratio of an SiO₂ film to an SiN film used as a conventional etching stopper film is about 9.5. It is known that an etching selection ratio of an SiO₂ film to an SiC film lowers to about 7. An etching selection ratio, particularly an etching selection ratio when an etching stopper film on the bottom of a via hole is used, lowers considerably. An etching selection ratio of an FSG film to an SiN film on the bottom of a via hole was about 28, whereas an etching selection ratio of an FSG film on an SiC film on the bottom of a via hole was about 17. A large reduction amount of the etching selection ratio when the etching is to be stopped at the bottom of the via hole may be ascribed to that the etching on the bottom of the via hole is governed more by chemical reaction than by sputtering.

Fig. 6 is a graph showing the results of Fourier transform infrared (FT-IR) spectroscopy of an SiC film having a relatively low etching rate under the etching conditions of SiO₂ or FSG. The abscissa represents a wave number in the unit of cm⁻¹ and the ordinate represents an absorbance. It can be seen that not only a peak caused by Si-C bonds but also a peak caused by Si-OCH bonds appear. The peak caused by Si-OCH bonds is more intense than the peak caused by Si-C bonds. It can be considered that since the Si-C film contains more Si-OCH bonds, the etching rate of the SiC film under the SiO etching conditions became fast.

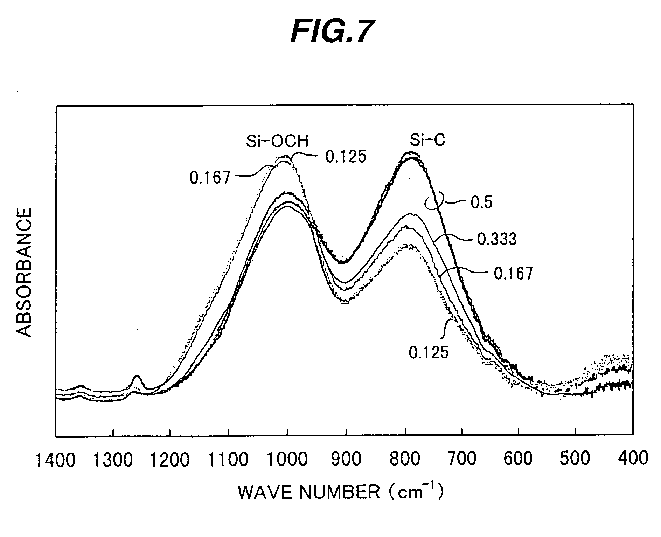

Fig. 7 is a graph showing the results of FT-IR spectroscopy of five SiC films formed under different film forming conditions. The Si-C films were formed by using tetramethylsilane and CO₂ as source gasses. Numerical values affixed to curves shown in Fig. 7 represent ratios of flow rates of tetramethylsilane to flow rates of CO₂.

As the flow rate ratio becomes large (as the flow rate of tetramethylsilane becomes large relative to CO₂), the peak caused by Si-C bonds becomes high. As the flow rate ratio becomes small, the peak caused by Si-OCH bonds becomes large. It can be known that more oxygen and hydrogen is captured in each SiC film.

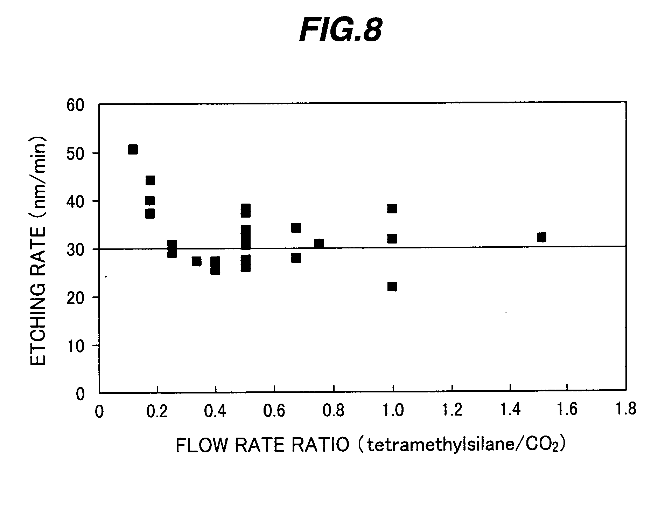

Fig. 8 is a graph showing a relation between a flow rate ratio between tetramethylsilane and CO₂ when SiC films are formed and an etching rate of each SiC film. The abscissa represents a ratio of a flow rate of tetramethylsilane to a flow rate of CO₂, and the ordinate represents an etching rate in the unit of "nm/min". The etching conditions used were as follows.

A flow rate of C₄F₈ was 8 sccm, that of C₅F₈ was 3 sccm, that of Ar was 320 sccm, that of CO was 190 sccm, and that of O₂ was 8 sccm. A pressure was about 4 Pa (30 mTorr), a source power was 1750 W, a bias power was 1400 W and a lower electrode temperature was 20 °C.

If the flow rate ratio is 0.2 or higher, the etching rates are scarcely influenced by the flow rates and distribute around 30 nm/min. It can be seen that the etching rate becomes fast in the range lower than 0.2. It is therefore preferable that the flow rate ratio between the source gasses is set to 0.2 or higher if the SiC film is utilized as an etching stopper film.

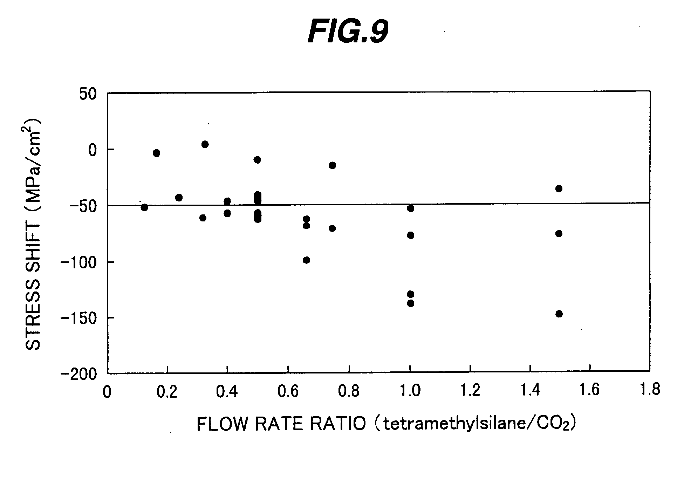

Fig. 9 is a graph showing a relation between a flow rate ratio between tetramethylsilane and CO₂ when SiC films are formed and a stress shift. The abscissa represents a ratio of a flow rate of tetramethylsilane to a flow rate of CO₂, and the ordinate represents a stress shift in the unit of "MPa/cm²". The stress shift was measured as a warp of each substrate after 10 to 12 days after the films were formed. It can be known that as the flow rate ratio is made large, the stress shift becomes large in the negative direction. Samples having large absolute values of stress shifts are found in a range particularly over a flow rate ratio of 0.6. A large stress shift means instability of the quality of an SiC film. It is therefore preferable to set the flow rate ratio to 0.6 or smaller.

As understood from the above-described studies, if an etching rate under the etching conditions for an SiO₂ film is slow and if the stable quality of an SiC film is to be obtained, it is preferable to set the ratio of a flow rate of tetramethylsilane to a flow rate of CO₂ to a range from 0.2 to 0.6, or more preferably to a range from 0.3 to 0.5.

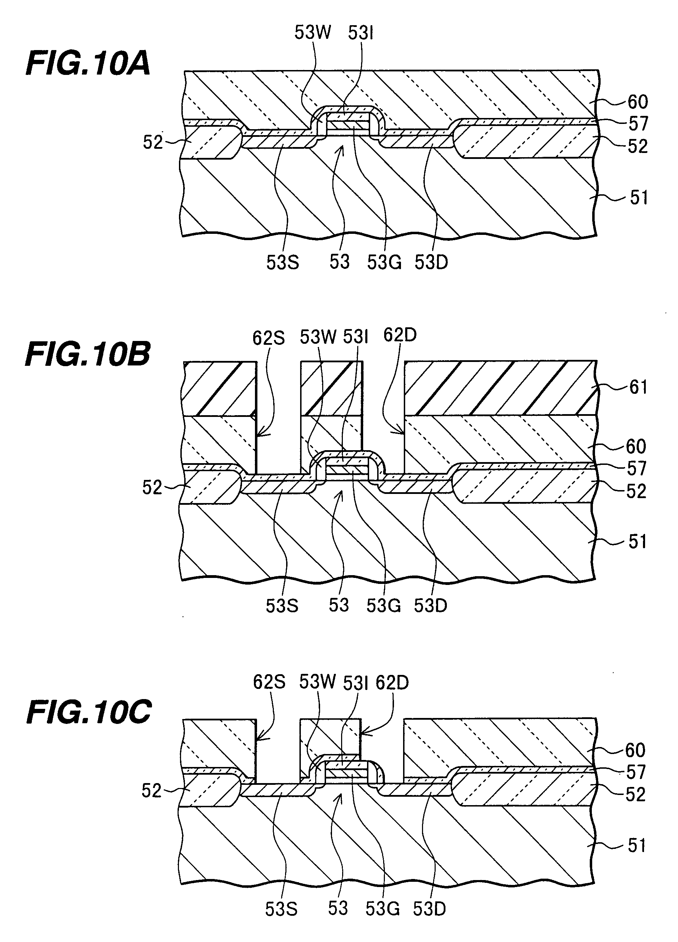

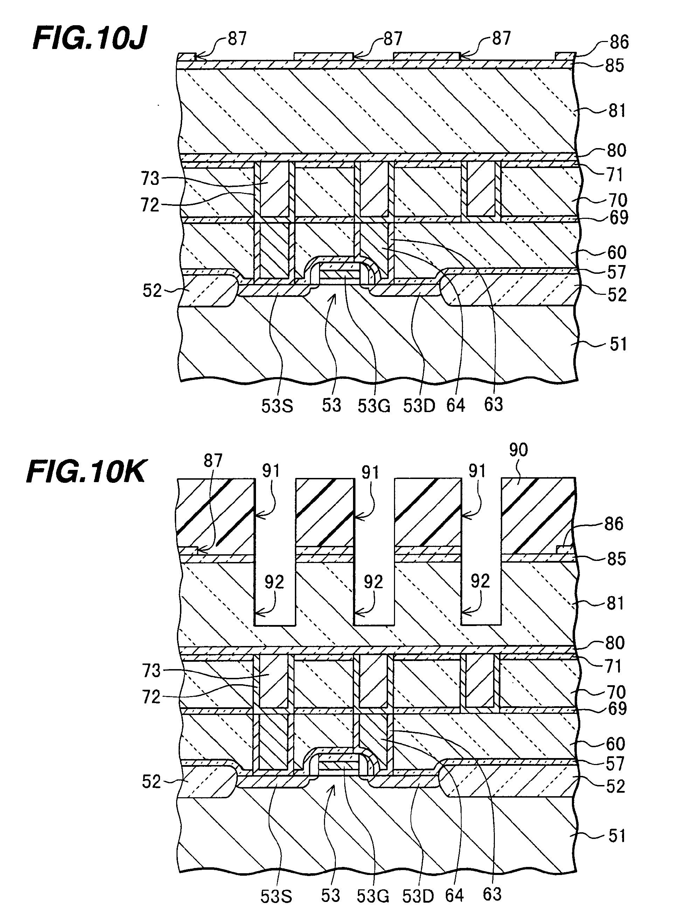

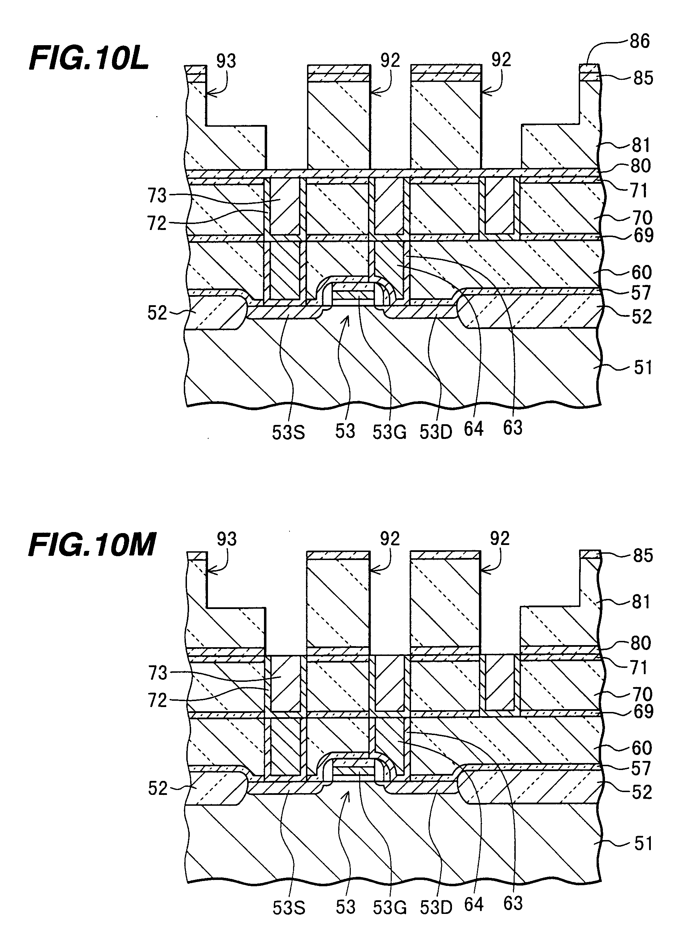

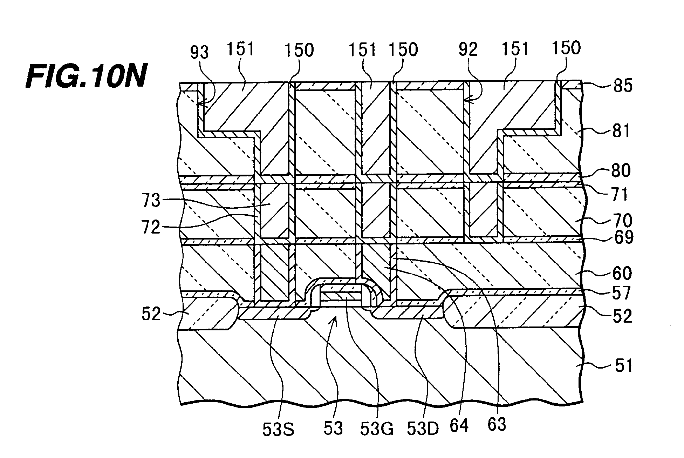

Next, with reference to Figs. 10A to 10N, description will be given for a method of manufacturing a semiconductor device by using a damascene method while the semiconductor manufacture methods according to the first to fifth embodiments are incorporated.

As shown in Fig. 10A, a silicon substrate 51 has on its surface an element separation insulating region 52. The element separation insulating region 52 is formed by silicon local oxidation (LOCOS) or shallow trench isolation (STI). An active region surrounded by the element separation insulating region 52 has a MOSFET including a gate electrode 53G, a source region 53S and a drain region 53D. The upper surface of the gate electrode 53G has an upper insulating film 531 of SiO₂. The sidewalls of the gate electrode 53G and upper insulating film 531 have sidewall spacers 53W. MOSFET 53 can be formed by repeating well-known photolithography, etching, ion implantation and the like.

On the surface of the substrate 51, an etching stopper film 57 made of SiC is formed covering MOSFET 53. The etching stopper film 57 is formed under the preferable film forming conditions described with the fifth embodiment. On this etching stopper film 57, an interlayer insulating film 60 of phosphosilicate glass (PSG) having a thickness of 500 nm is formed by chemical vapor deposition (CVD) and CMP.

Processes up to the state shown in Fig. 10B will be described. A resist mask 61 is formed on the surface of the interlayer insulating film 60. Openings are formed through the resist film 61 in the areas corresponding to the source region 53S and drain region 53D. By using the resist film 61 as a mask, the interlayer insulating film 60 is etched to form contact holes 62S and 62D in the areas corresponding to the source region 53S and drain region 53D. This etching stops at the etching stopper film 57. The resist film 61 is thereafter removed.

In the example shown in Fig. 10B, the contact hole 62D partially overlaps the gate electrode 53G as viewed along a line parallel to the normal to the substrate surface.

As shown in Fig. 10C, the etching stopper film 57 exposed on the bottom of the contact holes 62S and 62D is removed. This etching is performed under the preferable etching conditions described with the second embodiment. Partial surface areas of the source region 53S and drain region 53D are therefore exposed. Since the upper insulating film 531 is disposed on the gate electrode 53G, the gate electrode 53G is not exposed.

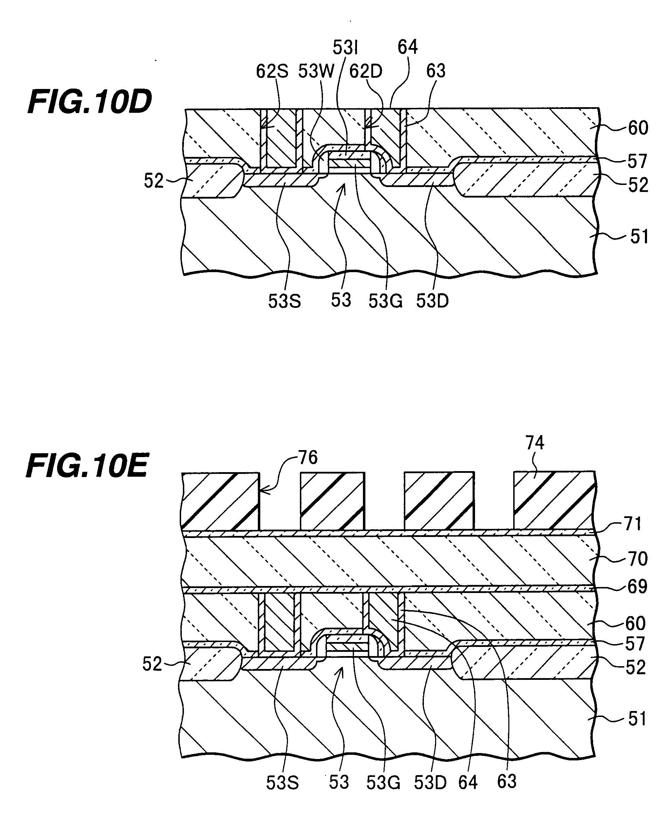

As shown in Fig. 10D, a barrier metal layer of 30 nm in thickness is formed covering the inner surfaces of the contact holes 62S and 62D and the upper surface of the etching stopper film 57. For example, the barrier metal layer 63 is made of Ti, TiN or TaN. On the surface of the barrier metal layer, a tungsten (W) layer is formed which has a thickness sufficient for burying the insides of the contact holes 62S and 62D with the tungsten layer. For example, the barrier metal layer and W layer are formed by CVD.

CMP is performed until the interlayer insulating film 60 is exposed to remove an unnecessary barrier metal layer and W layer. Conductive plugs 64 made of the barrier metal layer 63 and W layer are therefore left in the contact holes 62S and 62D.

As shown in Fig. 10E, on the interlayer insulating film 60, an etching stopper film 69 of SiC having a thickness of 50 nm is formed. On this etching stopper film 69, a first wiring layer insulating film 70 of 250 nm in thickness is formed. For example, the first wiring layer insulating film 70 is made of FSG.

On the first wiring layer insulating film 70, a cap film 71 of SiO₂ having a thickness of 150 nm is formed by plasma enhanced chemical vapor deposition. On the cap film 71, a resist pattern 74 is formed. The resist pattern 74 has openings 76 formed therethrough and corresponding to wirings to be formed in the first wiring layer insulating film 70. The openings 76 are formed by usual photolithography.

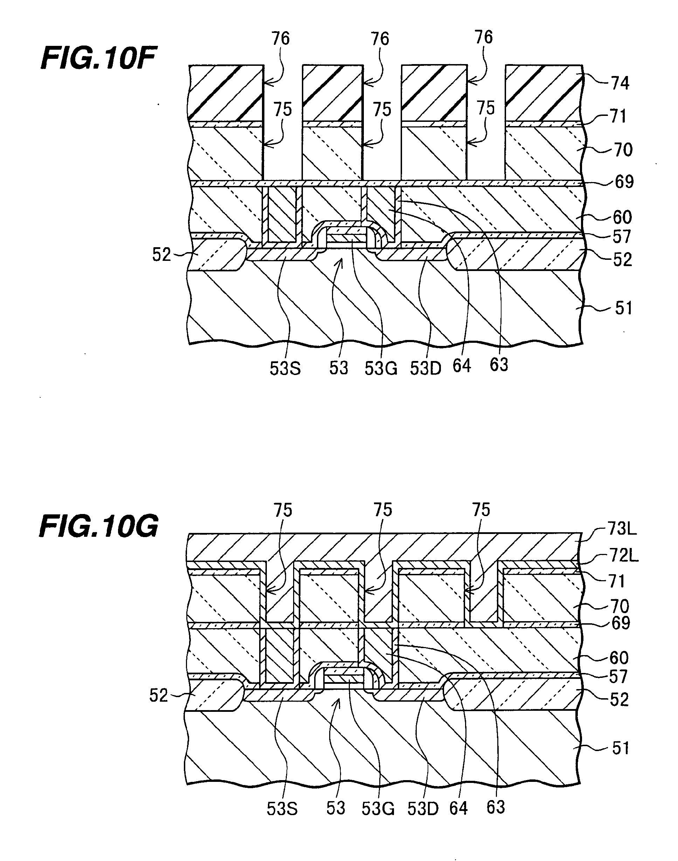

As shown in Fig. 10F, by using the resist pattern 74 as a mask, the cap layer 71 and first wiring layer insulating film 70 are etched. The cap layer 71 and first layer wiring film 70 are etched by RIE using mixture gas of C₄F₈, C₅F₈, Ar, CO and O₂ as etching gasses. This etching stops at the etching stopper film 69. Wiring grooves 75 corresponding to the openings 76 of the resist pattern 74 are therefore formed through the first wiring layer insulating film 70. After the wiring grooves 75 are formed, the resist pattern 74 is removed. Thereafter, the etching stopper film 69 exposed on the bottoms of the wiring grooves 75 is removed.

As shown in Fig. 10G, the upper surface of the conductive plug 64 is exposed on the bottom of the corresponding wiring groove 75. A barrier metal layer 72L of 25 nm in thickness is formed covering the inner surfaces of the wiring grooves 75 and the upper surface of the cap film 71. The barrier metal layer 72L is made of TiN or TaN and formed by sputtering. A conductive layer 73L of copper is formed on the surface of the barrier layer 72L. The conductive layer 73L is formed by covering the surface of the barrier metal layer 72L with a seed layer of Cu and then plating Cu, and has a thickness sufficient for burying the insides of the wiring grooves 75 with the conductive layer.

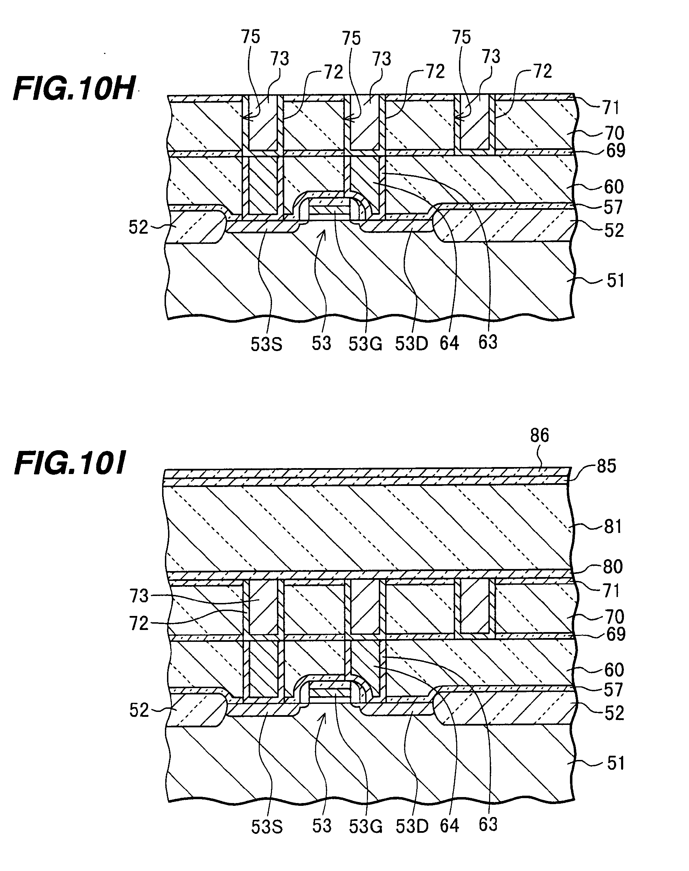

As shown in Fig. 10H, CMP is performed until the cap film 71 is exposed. The barrier metal layer 72 covering the inner surfaces of the wiring grooves 75 and the Cu wiring 73 burying the insides of the wiring grooves 75 are therefore left in the wiring grooves.

As shown in Fig. 101, on the cap film 71, a diffusion barrier film 80 of SiC having a thickness of 50 nm, an interlayer insulating film 81 of FSG having a thickness of 800 nm, a cap film 85 of SiO₂ having a thickness of 100 nm and a hard mask 86 of SiC having a thickness of 50 nm are sequentially deposited.

For example, the diffusion barrier film 80 is formed by the preferred film forming conditions described with the fifth embodiment, and the hard mask 86 is formed under the same conditions as those of forming the hard mask 5 of the first embodiment shown in Fig. 1A.

As shown in Fig. 10J, the hard mask 86 is patterned to form openings 87. The openings 87 correspond to wiring patterns to be formed in the wiring layer insulating film 81. The hard mask 86 is patterned under the conditions similar to those of etching the hard mask 5 of the first embodiment shown in Fig. 1B.

As shown in Fig. 10K, a resist pattern 90 is formed on the cap film 85 exposed on the bottoms of the openings 87 and on the hard mask 86. The resist pattern 90 has openings 91 corresponding to via holes to be formed through the interlayer insulating film 81. As viewed along a line parallel to the normal to the substrate surface, the openings 91 are included in the openings 87 formed through the hard mask 86. By using the resist pattern 90 as a mask, the cap film 85 is etched and the interlayer insulating film 81 is etched to the intermediate depth thereof to form via holes 92.

After the via holes 92 are formed, the resist pattern 90 is ashed and removed

As shown in Fig. 10L, by using the hard mask 86 as an etching mask, the interlayer insulating film 81 is etched from its upper surface to the intermediate depth to form wiring grooves 93. At this time, the bottom of the via hole 92 is further etched and the via hole 92 is eventually formed through the intermediate insulating film 81. This etching can be performed by RIE using mixture gas of C₄F₈, C₅F₈, Ar, CO and O₂ as etching gasses.

As shown in Fig. 10M, the hard mask 86 and diffusion barrier film 80 exposed on the bottoms of the via holes 92 are etched. This etching is performed under the conditions similar to those of etching the etching stopper film 13 of the second embodiment described with Fig. 3D.

As shown in Fig. 10N, the inner surfaces of the via holes 92 and the wiring grooves 93 are covered with a barrier metal layer 150 and the insides of the via holes and wiring grooves 93 are buried with a Cu wiring. The barrier metal layer 150 and Cu wiring 151 are formed by a method similar to that of forming the barrier metal layer 72 and Cu wiring 73 in the first wiring layer insulating film.

As described so far, an SiC film can be used as a hard mask or an etching stopper film. As compared to using SiN as conventional, parasitic capacitance between wiring patterns can be reduced so that a high speed operation of a semiconductor integrated circuit device is possible.

The present invention has been described in connection with the preferred embodiments. The invention is not limited only to the above embodiments. It is apparent that various modifications, improvements, combinations, and the like can be made by those skilled in the art.

## Claims

1. A method of manufacturing a semiconductor device, comprising steps of:
forming a first film on a semiconductor substrate, the first film being made of material having a different etching resistance from silicon carbide;
forming a second film on the first film, the second film being made of hydrogenated silicon carbide;
forming a resist film with an opening on the second film;
dry-etching the second film by using the resist mask as an etching mask and mixture gas of fluorocarbon gas added with at least one of SF₆ and NF₃; and
etching the first film by using the second film as a mask.

2. A method of manufacturing a semiconductor device, comprising steps of:
preparing a substrate having a conductive region exposed on a partial area of an insulating surface of the substrate;
forming a first film on the surface of the substrate, the first film being made of hydrogenated silicon carbide;
forming a second film made of insulating material on the first film;
forming a resist film with an opening on the second film;
etching the second film by using the resist mask as an etching mask to form a recess and expose a partial surface area of the first film on the bottom of the recess;
ashing and removing the resist film;
dry-etching the first film exposed on the bottom of the recess by using mixture gas of fluorocarbon gas added with at least one of SF₆ and NF₃ to expose the conductive region of the substrate; and

3. A method according to claim 2, wherein the conductive region exposed on the partial area of the insulating surface of the substrate is a copper wiring.

4. A method according to claim 3, wherein an upper surface of the copper wiring is covered with a barrier metal layer made of material selected from a group consisting of Ta, TaN, Ti and TiN.

5. A method according to claim 2, wherein the second film is a film selected from a group consisting of a silicon oxide film, a film of phosphosilicate glass, a film of borophosphosilicate glass, a film of fluorosilicate glass, a film of hydrogen silsesquioxane, a film deposited using tetraethylorthosilicate as a source, a film formed by spin-on-glass, a film of carbon-containing silicon oxide, a silicon-containing foaming porous film, and an insulating film of organic material.

6. A method according to claim 2, wherein the step of forming the first film forms the first film by chemical vapor deposition using tetramethylsilane and carbon dioxide as source gasses and by setting a ratio of a flow rate of tetramethylsilane to a flow rate of carbon dioxide to a range from 0.2 to 0.6.

7. A method of manufacturing a semiconductor device, comprising steps of:
preparing a substrate having a conductive member exposed on a partial area of an insulating surface of the substrate;
forming a first film on the surface of the substrate, the first film being made of hydrogenated silicon carbide;
forming a second film made of insulating material on the first film, the insulating material having a different etching resistance from silicon carbide;
forming a third film on the second film, the third film being made of hydrogenated silicon carbide;
forming a resist film with an opening on the third film, the opening overlapping with a partial area of the conductive member as viewed along a line parallel to a normal to the substrate surface;
etching the third film by using the resist mask as an etching mask and using mixture gas of fluorocarbon gas added with at least one of SF₆ and NF₃;
etching the second film by using the resist mask as an etching mask under a condition that an etching rate of the second film is faster than an etching rate of the first film, to form a recess and expose a partial surface area of the first film on a bottom of the recess;
ashing and removing the resist film; and
dry-etching the first film exposed on the bottom of the recess by using mixture gas of fluorocarbon gas added with at least one of SF₆ and NF₃, to expose the conductive member of the substrate.

8. A method according to claim 7, wherein the step of forming the first film the first film is formed by chemical vapor deposition using tetramethylsilane and carbon dioxide as source gasses and by setting a ratio of a flow rate of tetramethylsilane to a flow rate of carbon dioxide to a range from 0.2 to 0.6.

9. A method of manufacturing a semiconductor device, comprising steps of:
preparing a substrate having a wiring exposed on a partial area of an insulating surface of the substrate;
forming a first film on the surface of the substrate, the first film being made of hydrogenated silicon carbide;
forming a second film made of insulating material on the first film, the insulating material having a different etching resistance from silicon carbide;
forming a third film on the second film, the third film being made of hydrogenated silicon carbide;
forming a first resist film with a first opening on the third film, the first opening overlapping with a partial area of the conductive member as viewed along a line parallel to a normal to the substrate surface;
etching the third film by using the resist mask as an etching mask and using mixture gas of fluorocarbon gas added with at least one of SF₆ and NF₃ to expose a partial surface of the second film;
removing the first resist film;
forming a second resist film with a second opening on surfaces of the etched third film and exposed second film, the second opening being included in an area of the first opening and partially overlapping with the wiring;
etching the second film at least to an intermediate depth thereof by using the second resist mask as an etching mask;
removing the second resist film;
etching the third film by using the partially etched third film as a mask to form a via hole reaching the first film in an area where the second opening is formed, and to form a wiring groove to an intermediate depth of the second film in an area where the first opening is formed and the second opening is not formed;
dry-etching the first film exposed on the bottom of the via hole by using mixture gas of fluorocarbon gas added with at least one of SF₆ and NF₃, to expose the wiring; and
burying insides of the via hole and wiring groove with a conductive member.

10. A method according to claim 9, wherein the step of forming the first film the first film is formed by chemical vapor deposition using tetramethylsilane and carbon dioxide as source gasses and by setting a ratio of a flow rate of tetramethylsilane to a flow rate of carbon dioxide to a range from 0.2 to 0.6.

11. A method of manufacturing a semiconductor device, comprising steps of:
forming a first film of silicon carbide on a surface of a semiconductor substrate by chemical vapor deposition using tetramethylsilane and carbon dioxide as source gasses and by setting a ratio of a flow rate of tetramethylsilane to a flow rate of carbon dioxide to a range from 0.2 to 0.6;
forming a second film on the first film, the second film being made of insulating material having a different etching resistance from silicon carbide;
forming a resist film with an opening; and
etching the second film by using the resist film as an etching mask under a condition that an etching rate of the second film is faster than an etching rate of the first film to partially expose the first film.

12. A method according to claim 11, wherein the second film is made of fluorosilicate glass.
